# EUROPÄISCHE PATENTSCHRIFT

(11) **EP 2 655 687 B1**
(45) Veröffentlichungstag und Bekanntmachung des Hinweises auf die Patenterteilung: **27.02.2019**
(21) Anmeldenummer: 11819088.3
(22) Anmeldetag: 19.12.2011
(51) Int. Cl.: C23C 14/50, C23C 16/458, H01L 21/683, H01L 21/673

(54) **HALTEVORRICHTUNG FÜR SUBSTRATE SOWIE VERFAHREN ZUR BESCHICHTUNG EINES SUBSTRATES**
RETAINING DEVICE FOR SUBSTRATES AND METHOD FOR COATING A SUBSTRATE
DISPOSITIF DE SUPPORT POUR SUBSTRATS ET PROCÉDÉ DE REVÊTEMENT D'UN SUBSTRAT

(30) Priorität: 22.12.2010 DE 102010055675
(43) Veröffentlichungstag der Anmeldung: 30.10.2013
(73) Patentinhaber: Fraunhofer-Gesellschaft zur Förderung der angewandten Forschung e.V., 80686 München (DE)
(72) Erfinder: REBER, Stefan, 79194 Gundelfingen (DE); SCHILLINGER, Norbert, 79241 Ihringen (DE); ARNOLD, Martin, 79194 Gundelfingen (DE); POCZA, David, 79117 Freiburg (DE)
(74) Vertreter: Pfenning, Meinig & Partner mbB
(86) Internationale Anmeldenummer: PCT/EP2011/006419
(87) Internationale Veröffentlichungsnummer: WO 2012/084187

(56) Entgegenhaltungen:
- EP-A2- 0 669 642
- DE-A1-102004 063 855
- DE-T1- 19 882 014
- US-A- 5 999 589

## Beschreibung

Die vorliegende Erfindung betrifft eine Haltevorrichtung für zu beschichtende Substrate, die eine Auflagefläche für das zu beschichtende Substrat umfasst. Die Haltevorrichtung ist beispielsweise als Platte ausgestaltet, auf der das Substrat aufliegt, die dabei eine oder mehrere Aperturen, z.B. Durchbohrungen, Nuten etc. aufweist, über die ein Druckgradient zwischen Substratseite und der gegenüber liegenden Seite der Haltevorrichtung eingestellt werden kann. Dadurch ist eine temporäre Fixierung des Substrates durch Ansaugen auf der Haltevorrichtung möglich. Ebenso betrifft die vorliegende Erfindung ein Verfahren zur Beschichtung eines Substrates, das sich der erfindungsgemäßen Haltevorrichtung bedient.
Zur Senkung der Kosten von Beschichtungen muss eine Beschichtungsanlage möglichst gut zu skalieren sein.

Dabei treten folgende Herausforderungen zu Tage:
a) Partikel, die durch den Beschichtungsprozess oder einen eventuellen Transportprozess erzeugt werden, dürfen nicht auf die Oberfläche der zu beschichtenden Fläche fallen. Dies erzeugt Fehler in der Beschichtung, die je nach Anwendung bis zum Komplettausfall des Produkts führen können.
b) Die zu beschichtende Fläche sollte nicht durch Halterungen teilabgeschattet sein, so dass lokal keine Beschichtung stattfinden kann. Auch dadurch-können sich die gleichen Nachteile wie unter a) beschrieben ergeben.
c) Die Abscheidegeometrie (z.B. Abstand zur Quelle, Volumen des Beschichtungsraums) sollte möglichst gleich bleiben. Ungleiche Abscheidegeometrie führt z.B. zu inhomogenen Abscheideraten.

Die bisher bekannten Haltevorrichtungen für Substrate sehen beispielsweise Klammern oder Ähnliches vor, um ein Substrat auf der Haltevorrichtung zur Beschichtung zu befestigen. Eine derartige mit einem Substrat versehene Haltevorrichtung kann dann face-down angeordnet werden.

Beispielsweise bei PECVD-Anlagen wird derzeit routinemäßig das Substrat mit der zu beschichtenden Fläche nach unten angeordnet und von unten beschichtet. Dadurch erreicht man, dass Partikel nicht auf die Fläche fallen können.

Nachteilig hierbei ist allerdings, dass bei einer mechanischen Fixierung des Substrates durch Klammern etc. eine teilweise Abschattung des Substrates unumgänglich ist, so dass stets beim Beschichtungsvorgang nicht die komplette Fläche des Substrates der Beschichtung zugeführt werden kann.
Alternativ hierzu ist die face-up-Anordnung der Substrate möglich. Dabei wird die zu beschichtende Fläche nach oben ausgerichtet. Das Substrat kann somit auf der Haltevorrichtung ohne Abschattung der zu beschichtenden Fläche aufliegen. Nachteilig hierbei ist allerdings, dass die Möglichkeit nicht ausgeschlossen werden kann, dass Partikel schwerkraftbedingt auf die Oberfläche des zu beschichtenden Substrates fallen und somit unzulängliche Reinheitsgrade beim Beschichtungsprozess erzielt werden können.

Eine Haltevorrichtung ist aus DE102004063855 bekannt.

Ausgehend hiervon ist es somit Aufgabe der vorliegenden Erfindung, eine Haltevorrichtung zur Halterung von Substraten in einer Beschichtungsanlage anzugeben, die es erlaubt, zu beschichtende Substrate zuverlässig zu halten, ohne dass die Substrate durch mechanische Haltevorrichtungen abgeschattet werden, und zum anderen gewährleistet, dass Partikel nicht durch Gravitation auf das Substrat fallen, wenn dieses face-up-angeordnet ist, wie dies der Fall wäre. Ebenso ist es Aufgabe der vorliegenden Erfindung, eine entsprechende Beschichtungsanlage sowie ein Verfahren zur Beschichtung eines Substrates anzugeben.
Diese Aufgabe wird bezüglich der Haltevorrichtung mit den Merkmalen des Patentanspruchs 1, bezüglich der Beschichtungsanlage mit den Merkmalen des Patentanspruchs 4 sowie bezüglich des Verfahrens zur Beschichtung des Substrates mit den Merkmalen des Patentanspruchs 6 gelöst. Mit Patentanspruch 10 werden Verwendungszwecke angegeben. Die jeweiligen abhängigen Patentansprüche stellen dabei vorteilhafte Weiterbildungen dar.

Erfindungsgemäß wird somit eine Haltevorrichtung für zu beschichtende Substrate beschrieben, die eine Auflagevorrichtung für das zu beschichtende Substrat, mit einer flächig ausgebildeten Vorderseite zur Auflage des Substrates sowie einer der Vorderseite gegenüberliegende Rückseite, umfasst. Die erfindungsgemäße Haltevorrichtung zeichnet sich dadurch aus, dass mindestens eine durchgehende, die beiden Seiten der Auflagevorrichtung verbindende Apertur vorhanden ist, über die eine Druckregulierung des zwischen den beiden Seiten der Auflagevorrichtung herrschenden Gasdruckes möglich ist.

Erfindungsgemäß ist durch die Haltevorrichtung somit ermöglicht, dass ein zu beschichtendes Substrat auf die Auflagevorrichtung aufgelegt wird. Bevorzugt zu beschichtende Substrate sind dabei flach ausgebildet, ebenso ist demnach die Oberfläche der Auflagevorrichtung, auf der das Substrat aufliegt, entsprechend der Oberfläche des Substrates, also ebenso flach ausgebildet, so dass das Substrat formschlüssig auf der Oberfläche der Auflagevorrichtung aufliegen kann. Über die Aperturen, die in der Auflagevorrichtung vorhanden sind, kann nun ein verminderter Druck angelegt werden, so dass das Substrat über den verminderten Druck, der auf der der Substratseite abgewandten Seite der Auflagevorrichtung herrscht, an die Auflagevorrichtung angepresst oder angesaugt und somit fixiert werden kann. Somit ist eine Halterung des Substrates in allen möglichen Raumrichtungen, also beispielsweise auch face-down, möglich, so dass ein Substrat auf die vorangehend beschriebene Weise mit der erfindungsgemäßen Haltevorrichtung bei einem Beschichtungsverfahren zumindest temporär fixiert werden kann.

Das Wesen der Erfindung besteht somit darin, dass
- geeignete Substrathalter vertikal oder horizontal (face-down) angeordnet werden,
- die Druckverhältnisse in der Beschichtungsanlage so etabliert werden, dass auf der zu beschichtenden Seite ein höherer Gasdruck herrscht als auf der Rückseite des Substrathalters,
- durch geeignete Bohrungen im Substrathalter ein Druckausgleich zwischen Rückseite des Wafers und Rückseite des Substrathalters erreicht wird,
und damit das Substrat durch den erhöhten Gasdruck auf den Träger gepresst wird.

Durch die Erfindung werden daher die eingangs erwähnten Probleme vollständig beseitigt; d.h.:
- Partikel fallen im Wesentlichen nicht auf die Oberfläche, da die Substrate senkrecht oder face-down angeordnet sind, die "Aperturfläche" der Substrate zur Gravitation ist idealerweise null, realerweise sehr gering, d.h. Verminderung des Risikos der Kontamination der Oberfläche mit Partikeln.
- Abschattung der zu beschichtenden Fläche durch mechanische Sicherungen des Substrats kann komplett vermieden werden. Eventuell vorhandene mechanische Sicherungen, die das Substrat außerhalb des Abscheidebereichs halten, wirken sich während der Abscheidung nicht aus. Somit wird eine vollflächigen Beschichtung der Fläche ohne Abschattung durch Halterungen/Pins ermöglicht.
- Durch die vertikale Anordnung kann der Abscheidebereich leicht skaliert werden. Erweiterungen in vertikaler Richtung lassen die Abscheidegeometrie gleich, im Gegensatz z.B. zu gekippten Substratanordnungen. Es bestehen somit keine Einschränkungen der Größen-Skalierbarkeit.
Eine bevorzugte Ausführungsform sieht vor, dass die Auflagevorrichtung über 2 bis 100, bevorzugt 2 bis 10 durchgehende, von der einen zur anderen Seite verlaufende Aperturen verfügt. Insbesondere bei einer hohen Anzahl an Aperturen wird von "porösen Haltern" gesprochen.
Rückseitig an die mindestens eine Apertur kann eine Vorrichtung zur Erzeugung eines Unterdrucks angeschlossen ist. Diese Vorrichtung kann beispielsweise als Gebläse, Pumpe, etc. ausgebildet sein, maßgeblich dabei ist alleinig, dass mit der Vorrichtung ein Unterdruck ausgebildet werden kann, der gegenüber dem Innenraum, d.h. der Substratseite der Auflagevorrichtung, angelegt werden kann. Die Vorrichtung zur Erzeugung des Unterdrucks kann dabei in üblicher Art und Weise mit den Aperturen in Verbindung stehen, beispielsweise durch Schläuche etc. Ebenso ist es möglich, dass die der Substratseite abgewandte Seite der Auflagevorrichtung einen Raum begrenzt, der mit Unterdruck beaufschlagt werden kann und sich der so angelegte Unterdruck auf die Substratseite fortsetzt.

Nach Anspruch 1 sind dabei mindestens zwei gegenüberliegend angeordnete Arme vorgesehen, die durch Wandungen und Innenkanten begrenzt werden, wobei die Auflagevorrichtung und die Arme einen Bereich begrenzen, in den das zu beschichtende Substrat aufgenommen werden kann. Die innen liegenden, dem Bereich für das Substrat zugewandten Wandungen der Arme weisen dabei bezüglich der Auflagefläche für das Substrat der Auflagevorrichtung einen Winkel von < 90° auf. Die Erfindung sieht vor, dass an den beiden Enden der Auflagevorrichtung zwei Arme angeordnet sind, die auch beispielsweise als Hohlkehle, Klammer oder Haken ausgebildet sein können. Wesentlich dabei ist, dass die Arme einwärts, d.h. zur Auflagefläche für das Substrat hin geneigt sind. Das Substrat kann somit für den Fall, dass es so bemessen ist, dass es länger ist als die durch die Kanten der Arme definierte Öffnung, nicht mehr in Richtung der Arme aus der Haltevorrichtung entfernt werden. Die Arme dienen somit der Sicherung des Substrates, für den Fall, dass dieses nicht, wie oben beschrieben, durch Unterdruck auf die Auflagefläche der Auflagevorrichtung fixiert ist.

Über die Wahl des o.g. Winkels und die Länge der Arme der Haltevorrichtung kann daher eine Reduktion der Öffnung der zwischen den Armen befindlichen Apertur erzielt werden. Die Wahl des jeweiligen Winkels und der Länge der Arme der Haltevorrichtung hängt dabei vom jeweiligen Substrat ab. Die Halteelemente sollten so dimensioniert sein, dass das Substrat ohne Ansaugung nicht herauskippt. Der konkrete Winkel oder Länge und Höhe einer Klammer bzw. Hohlkehle hängt somit von der Größe des Substrats und der Auflagefläche bzw. davon ab, wie viel Spiel das Substrat auf der Auflagefläche hat.
Erfindungsgemäß wird ebenso eine Beschichtungsanlage bereitgestellt, die mindestens eine im Voranstehenden beschriebene Haltevorrichtung aufweist.

Die erfindungsgemäße Beschichtungsanlage kann bevorzugt so ausgebildet sein, dass die erfindungsgemäße Haltevorrichtung in einem abgeschlossenen Beschichtungsraum untergebracht ist.

Dieser Beschichtungsraum kann mit einer oder mehreren Beschichtungsquellen in Verbindung stehen, alternativ oder zusätzlich hierzu können die Beschichtungsquellen jedoch auch im Beschichtungsraum untergebracht sein.

Die Aperturen der Haltevorrichtung können über entsprechende Verbindungen mit einer Unterdruckvorrichtung in Verbindung stehen, wobei die Vorrichtung zur Erzeugung eines Unterdrucks bevorzugt außerhalb des Beschichtungsraumes angebracht ist. Die Verbindungen zwischen den Aperturen der Haltevorrichtung und der Unterdruckvorrichtung können auch in Form von Kanälen ausgebildet sein, die beispielsweise in die Wandung des Beschichtungsraumes eingelassen sind. Somit lassen sich Schlauchverbindungen zwischen der Haltevorrichtung und der Unterdruckvorrichtung vermeiden; dies ermöglicht insbesondere die Verwendung der Beschichtungsvorrichtung für Hochtemperaturanwendungen.

In einer weiter bevorzugten Ausführungsform ist der Beschichtungsraum so ausgebildet, dass er geöffnet werden kann, um entsprechende Substrate in die Beschichtungsvorrichtung einzubringen oder nach Abschluss des Beschichtungsvorgangs zu entnehmen.

Die Beschichtungsquelle kann dabei beispielsweise ausgewählt sein aus thermischen Verdampfern, PVD- und/oder CVD-Beschichtungsquellen.

Weiter wird erfindungsgemäß ein Verfahren zur Beschichtung eines Substrates angegeben, das sich dadurch auszeichnet, dass mindestens ein zu beschichtendes Substrat in eine Haltevorrichtung einer im Voranstehenden beschriebenen Beschichtungsanlage eingebracht, auf der Auflagevorrichtung temporär fixiert sowie im Anschluss beschichtet wird.

In einer bevorzugten Ausführungsform erfolgt die temporäre Fixierung dadurch, dass der Gasdruck im Innenraum (pᵢ) relativ zum Gasdruck im Außenraum (pₐ) erhöht wird, bevorzugt mit der Vorrichtung zur Erzeugung eines Unterdrucks. Der Druckunterschied muss dabei so gewählt werden, dass das Substrat in jeder räumlichen Ausrichtung der Haltevorrichtung (also z.B. auch in einer face-down Ausrichtung des Substrates) auf der vorgesehenen Auflagefläche durch den herrschenden Unterdruck fixiert bleibt.

Beim Beschichtungsverfahren, d.h. beim Beschichtungsvorgang, ist es insbesondere vorteilhaft, wenn die Haltevorrichtung mit dem fixierten Substrat vertikal, diagonal oder horizontal angeordnet ist, wobei im Falle der diagonalen und der horizontalen Anordnung das zu beschichtende Substrat mit der zu beschichtenden Fläche nach unten angeordnet ist.

Die Beschichtung kann dabei insbesondere mittels Hochtemperaturbeschichtungsverfahren, CVD-Prozessen, wie z.B. PECVD-Verfahren, sowie dem Atmosphärendruck-CVD-Verfahren, wie z.B. der thermische APCVD, und/oder PVD-Prozessen, insbesondere Sputterverfahren, durchgeführt werden.

Verwendungsmöglichkeiten sowohl der Haltevorrichtung, der Beschichtungsanlage sowie des dargestellten Verfahrens finden sich insbesondere bei der Beschichtung, Sinterung und/oder Vergütung von Wafern, Blechen und/oder Keramiken.

Besonderer Vorteil der Erfindung ist, dass keine zusätzlichen Halterungen, wie z.B. Edelstahlpins etc., erforderlich sind. Die Haltevorrichtung bietet somit insbesondere im Hochtemperaturbereich der o.g. Anwendungen Vorteile.

Die vorliegende Erfindung wird anhand der nachfolgenden beigefügten Figuren näher beschrieben, ohne die Erfindung auf die dort dargestellten speziellen Parameter zu beschränken.

Es zeigt
- Figur 1a+b: eine erfindungsgemäße Haltevorrichtung 1 in vertikaler Anordnung vor und nach Ansaugung;
- Figur 2a+b: eine Anordnung sowie eine Verfahrensführung, bei der ein Substrat horizontal face-down gehalten werden kann, vor und nach Ansaugung;
- Figur 3a+b: die gleiche, in Figuren 1 bzw. 2 dargestellte Situation für den Fall dar, dass der Substrathalter 1 schräg, d.h. diagonal angeordnet ist, vor und nach Ansaugung; sowie
- Figur 4+5: je eine erfindungsgemäße Beschichtungsvorrichtung.

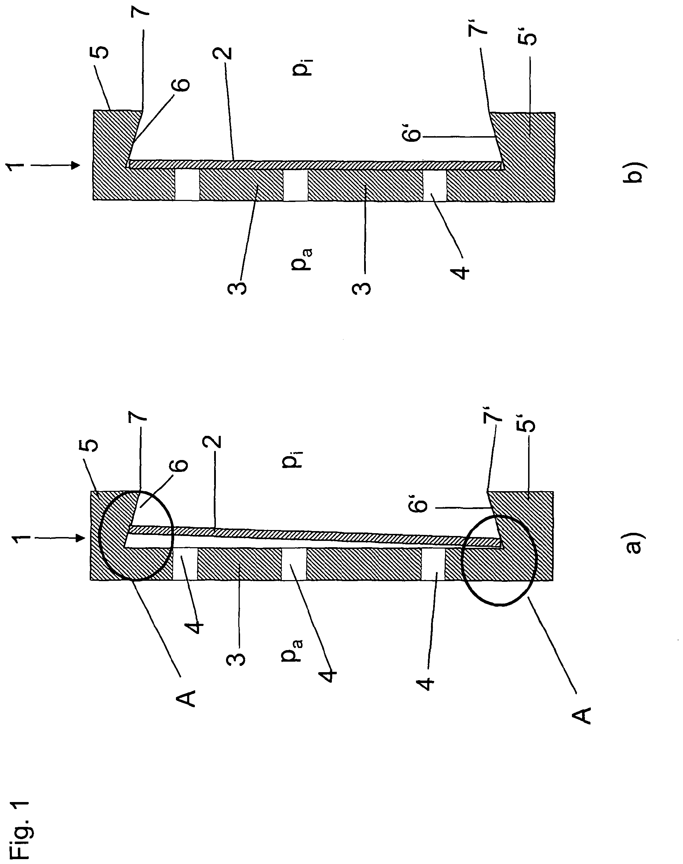

Figur 1 zeigt eine erfindungsgemäße Haltevorrichtung 1 in vertikaler Anordnung einmal vor (Fig. 1a) und nach (Fig. 1b) Ansaugung des Substrates. Die Haltevorrichtung 1 umfasst dabei eine Auflagevorrichtung 3 (die auch als Substratträger bezeichnet werden kann), wobei sich in dem dargestellten Querschnitt drei Aperturen 4 in Form von Durchbohrungen durchgängig durch die Auflagevorrichtung 3 befinden. An den beiden Seiten der Auflagevorrichtung 3 wird diese durch zwei einstückig mit der Auflagevorrichtung 3 ausgebildete Arme 5, 5' flankiert. Die Arme 5, 5' weisen dabei jeweils eine innen liegende Wandung 6, 6' auf, die abgeschrägt ausgebildet ist. Bei der hier dargestellten Vorrichtung 1 beträgt der Winkel, den die Wandungen 6, 6' jeweils mit der Auflagefläche des Substratträgers 3 für das Substrat 2 einschließen, z.B. ca. 75°. Es sind jedoch auch größere oder kleinere Winkel denkbar. Ebenso ist es möglich, dass die Winkel an beiden Armen 5, 5' unterschiedlich ausgebildet sind. Die beiden Wandungen 6, 6' werden jeweils durch endständige Innenkanten 7, 7' begrenzt. Der Abstand der Kante 7 zur gegenüber liegenden Kante 7' ist durch die abgeschrägte Ausbildung der Wandungen 6, 6' kleiner als die entsprechende Länge der Auflagefläche der Auflagevorrichtung 3 für das Substrat 2. Für den Fall, dass ein entsprechend groß dimensioniertes Substrat 2 in die Haltevorrichtung 1 eingeführt wird (wie dies in den Figuren 1a und 1b der Fall ist), kann somit ein direktes Einlegen des Substrates 2 von der in der Figur 1 dargestellten rechten Seite in die Haltevorrichtung 1 nicht erfolgen. Das Substrat 2 muss daher beispielsweise in Bildebene nach hinten in die Haltevorrichtung 1 eingeführt werden. Dadurch ist es jedoch unmöglich, dass das Substrat 2 aus der Haltevorrichtung 1 in Richtung der Arme 5, 5' aus der Haltevorrichtung heraus fallen kann. Ferner ist in Figur 1 mit pₐ der auf der der Auflagefläche für das Substrat 2 abgewandten Seite der Haltevorrichtung 1 vorherrschende Gasdruck bezeichnet, während pᵢ den Druck bezeichnet, der auf der Seite des Substrates herrscht. In Figur 1a ist nunmehr die Bedingung dargestellt, dass der Druck pᵢ ≤ pₐ beträgt, so dass das Substrat nicht an der Auflagefläche des Substrathalters 3 fixiert ist. Wird nun der Druck so eingestellt, dass pᵢ ≥ pₐ beträgt, tritt eine in Figur 1b dargestellte Situation ein, dass nämlich das Substrat 2 an die Auflagefläche des Substrathalters 3 angesaugt und dort über den herrschenden Unterdruck (bzw. aus der Perspektive des Innenraums ein Überdruck pᵢ) fixiert wird.

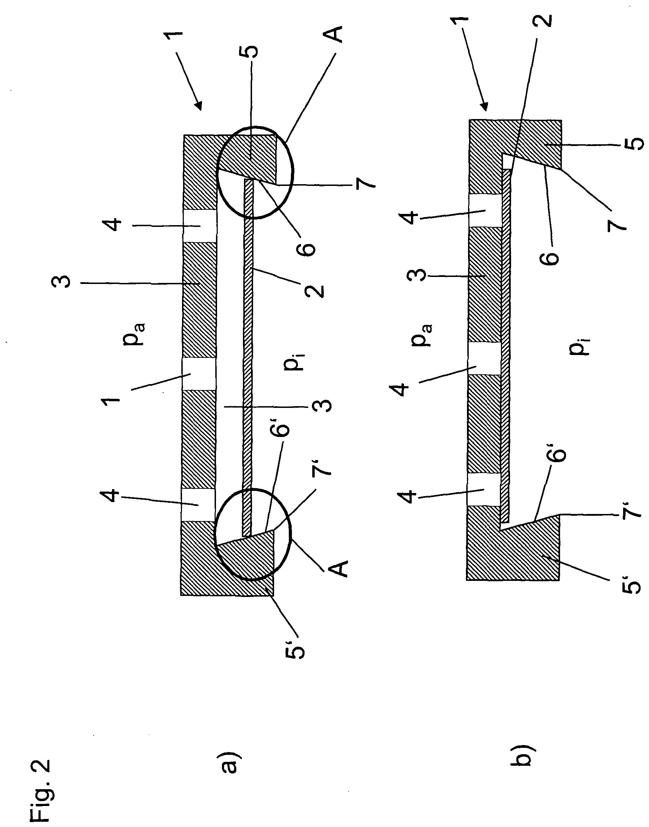

Eine entsprechende Anordnung sowie eine Verfahrensführung, bei der ein Substrat horizontal face-down gehalten werden kann, ist in Figur 2 dargestellt. Dabei werden die gleichen Bezugszeichen wie bereits in Fig. 1 verwendet. Insbesondere in Fig. 2a ist nochmals ersichtlich, dass die Haltevorrichtung 1 so dimensioniert ist, dass das Substrat nicht aus der Haltevorrichtung 1 heraus fallen kann. Dafür sind die abgeschrägten Arme 5 mit den schräg geführten Wandungen 6, 6' verantwortlich. Auch hier kann das Substrat 2 durch einfaches Absenken des Außendruckes formschlüssig mit der Auflagefläche des Substrathalters 3 verbunden bzw. fixiert werden, so dass eine in Fig. 2b dargestellte Situation resultiert.

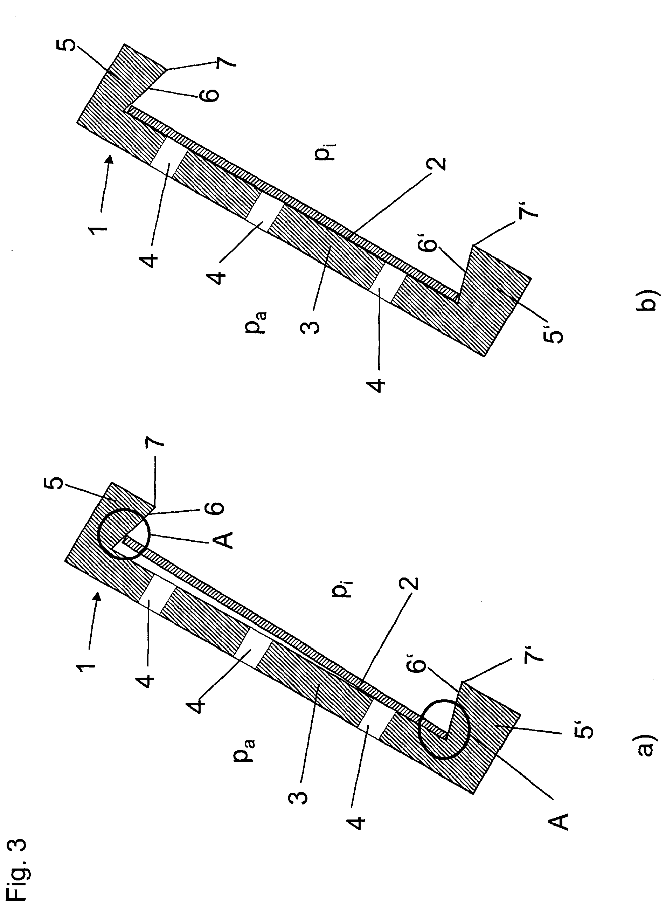

Die Figuren 3a und 3b stellen die gleiche, in Figuren 1 bzw. 2 dargestellte Situation für den Fall dar, dass der Substrathalter 1 schräg, d.h. diagonal angeordnet ist.

Aus den Figuren wird somit ersichtlich, dass mittels der erfindungsgemäßen Haltevorrichtung 1 ein quasi universelles Fixieren eines Substrates 2 möglich ist. Für den Fall, dass das Substrat in seiner Ausdehnung länger bemessen ist als der Abstand der Kanten 7 und 7', kann zudem verhindert werden, dass das Substrat aus der Haltevorrichtung bei Abwesenheit eines Unterdruckes an den Aperturen 4 aus der Haltevorrichtung 1 heraus fällt.

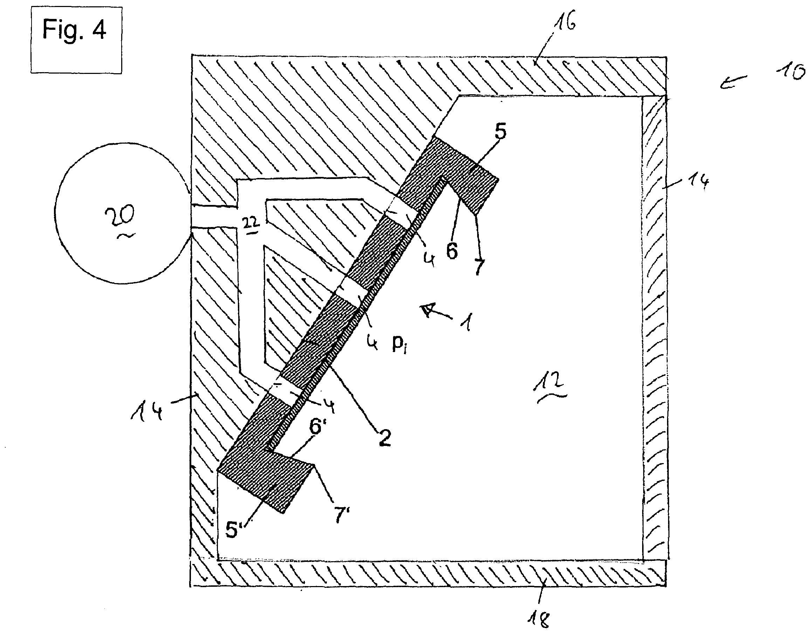

Fig. 4 zeigt schematisch eine erfindungsgemäße Beschichtungsanlage 10 mit einer erfindungsgemäßen Haltevorrichtung 1. Die Beschichtungsanlage weist einen Beschichtungsraum 12 auf, der beispielsweise von Wänden 14, einer Decke 16 und einem Boden 18 gebildet sein kann, die ein Raumvolumen begrenzen. In dem Beschichtungsraum 12 befinden sich wenigstens eine erfindungsgemäße Haltevorrichtung 1 zur Aufnahme eines oder mehrerer Substrate 2.

Der Beschichtungsraum 12 ist abgeschlossen und kann mit einer oder mehreren Beschichtungsquellen in Verbindung gebracht werden, um ein Beschichtungsmedium, z.B. ein Gas, in das Raumvolumen des Beschichtungsraums zu bringen. Alternativ oder zusätzlich kann der Beschichtungsraum auch eine oder mehrere Beschichtungsquellen enthalten.

Die Haltevorrichtung 1 weist wie vorbeschrieben Aperturen 4 auf. Die Aperturen sind mit einer Unterdruckvorrichtung 20 zur Erzeugung eines Unterdrucks relativ zum Druck im Volumen des Gasraumes verbunden, um das Substrat in der Haltevorrichtung zu fixieren. Vorteilhaft sind die Verbindungen der Aperturen zur Unterdruckvorrichtung in der Haltevorrichtung sowie in Boden, Decke und/oder den Wänden des Beschichtungsraums integriert, beispielsweise als Kanäle 22, so dass bei Hochtemperaturbeschichtungsanlagen keine temperaturempfindlichen Schlauch- oder Rohrverbindungen erforderlich sind. Die Haltevorrichtung kann auch erst für den Beschichtungsvorgang in den Beschichtungsraum eingebracht werden. Dies hat den Vorteil, dass die Haltevorrichtungen leichter zu reinigen sind. Dabei kann das Substrat beim Einbringen der Haltevorrichtung bereits in der Haltevorrichtung angebracht sein. In diesem Fall ist es besonders vorteilhaft, dass das Substrat von den Halteelementen 5 gesichert ist, bevor es durch den Unterdruck temporär fixiert wird.

Der Beschichtungsraum kann geöffnet werden, um die Haltevorrichtung manuell einzubringen. Alternativ kann die Haltevorrichtung über eine Fördervorrichtung automatisiert eingebracht werden. Die Haltevorrichtung kann durch schnell zu lösende, automatische oder selbstverriegelnde Befestigungselemente im Beschichtungsraum befestigt sein, so dass sie einfach eingebracht und nach dem Beschichtungsvorgang oder zur Reinigung oder Wartung wieder entnommen werden kann.

Vorteilhaft sind in Boden, Decke und/oder den Wänden des Beschichtungsraumes die Verbindungen zur Unterdruckvorrichtung so integriert, dass die Verbindung zur Unterdruckvorrichtung ohne weiteres hergestellt wird, wenn die Haltevorrichtung befestigt, oder über die Fördervorrichtung eingebracht wird.

In einer vorteilhaften Ausführung können auch Wände und/oder Decke ganz oder teilweise durch eine oder mehrere der Haltevorrichtungen selbst gebildet sein. In einer derartigen Ausführungsform kann der Beschichtungsraum selbst wiederum besonders vorteilhaft in einem abgeschlossenen Raumvolumen untergebracht sein, welches mit einem Unterdruck beaufschlagt wird.

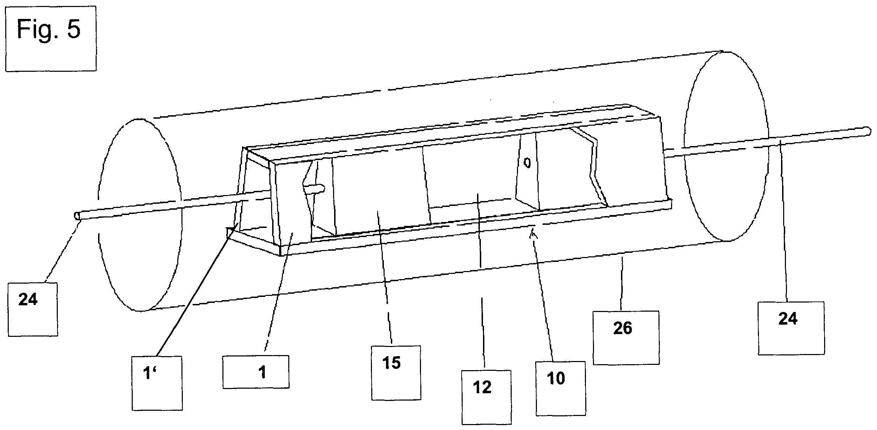

Eine solche besonders vorteilhafte Ausführungsform zeigt Fig. 5.

In der Beschichtungsanlage 10 in Fig. 5 ist ein Beschichtungsraum 12 gezeigt, bei dem zwei Haltevorrichtungen 1, 1' die vordere und hintere Begrenzungswand des Beschichtungsraumes 12 bilden. Die vordere Haltevorrichtung 1 ist aufgeschnitten, um das Innere des Beschichtungsraumes 12 zu zeigen. Stirnwände 15 sind mit Bohrungen (nicht dargestellt) versehen, an welche Gaszuleitungen 24 angeschlossen werden, durch die das Beschichtungsmedium zu- und abgeführt werden kann. Der Beschichtungsraum ist in einem Rohr 26 untergebracht, welches mit einem Unterdruck beaufschlagt werden kann. Dadurch werden die Substrate in den Haltevorrichtungen temporär fixiert, da die Aperturen in den Haltevorrichtungen mit dem Innenraum des Rohrs in Verbindung stehen.

## Patentansprüche

1. Haltevorrichtung (1) für zu beschichtende Substrate (2), umfassend eine Auflagevorrichtung (3) für das zu beschichtende Substrat (2), die eine flächig ausgebildete Vorderseite zur Auflage des Substrates (2) sowie eine der Vorderseite gegenüberliegende Rückseite aufweist, wobei mindestens eine durchgehende, die beiden Seiten der Auflagevorrichtung (3) verbindende Apertur (4) vorhanden ist, über die eine Regulierung des auf der Seite des Substrates (2) herrschenden Gasdruckes möglich ist,
**dadurch gekennzeichnet,**
**dass** die Auflagevorrichtung (3) von mindestens zwei gegenüber liegenden Halteelementen begrenzt ist, wobei die Halteelemente durch mindestens zwei gegenüberliegend angeordnete Arme (5, 5') gebildet werden, die durch Wandungen (6, 6') und Innenkanten (7, 7') begrenzt werden, wobei die Auflagevorrichtung (3) und die Arme (5, 5') einen Bereich begrenzen, in den das zu beschichtende Substrat (2) aufgenommen werden kann und die innen liegenden, dem Bereich für das Substrat (2) zugewandten Wandungen (6, 6') der Arme (5, 5') einen Winkel bezüglich der Auflagefläche für das Substrat (2) der Auflagevorrichtung (3) von < 90° aufweisen.

2. Haltevorrichtung (1) nach Anspruch 1, **dadurch gekennzeichnet, dass** die Auflagevorrichtung (3) über 2 bis 100, bevorzugt 2 bis 10 Aperturen (4) verfügt.

3. Haltevorrichtung (1) nach einem der vorhergehenden Ansprüche, **dadurch gekennzeichnet, dass** rückseitig an die mindestens eine Apertur (4) eine Vorrichtung zur Erzeugung eines Unterdrucks angeschlossen ist.

4. Beschichtungsanlage (10) umfassend mindestens eine Haltevorrichtung (1) nach einem der vorhergehenden Ansprüche.

5. Beschichtungsanlage nach vorhergehendem Anspruch, **dadurch gekennzeichnet, dass** die Beschichtungsanlage einen rohrförmigen Beschichtungsinnenraum aufweist, der mindestens zwei Haltevorrichtungen aufweist.

6. Verfahren zur Beschichtung eines Substrates (2), **dadurch gekennzeichnet, dass** mindestens ein zu beschichtendes Substrat (2) in eine Haltevorrichtung (1) einer Beschichtungsanlage nach einem der beiden vorhergehenden Ansprüche, eingebracht, auf der Auflagevorrichtung (3) temporär fixiert sowie im Anschluss beschichtet wird.

7. Verfahren nach vorhergehendem Anspruch, **dadurch gekennzeichnet, dass** die temporäre Fixierung dadurch erfolgt, dass der Gasdruck im Innenraum (pᵢ) relativ zum Gasdruck im Außenraum (pₐ) erhöht wird, bevorzugt mit der Vorrichtung zur Erzeugung eines Unterdrucks.

8. Verfahren nach einem der beiden vorhergehenden Ansprüche, **dadurch gekennzeichnet, dass** die Haltevorrichtung (1) mit dem fixierten Substrat (2) während des Beschichtungsvorganges vertikal, diagonal oder horizontal angeordnet ist, wobei im Falle der diagonalen und der horizontalen Anordnung das zu beschichtende Substrat (2) mit der zu beschichtenden Fläche nach unten angeordnet ist.

9. Verfahren nach einem der Ansprüche 6 bis 8, **dadurch gekennzeichnet, dass** die Beschichtung mittels Hochtemperaturbeschichtungsverfahren, CVD- und/oder PVD-Prozesse, insbesondere Sputterverfahren, oder PECVD-Verfahren erfolgt.

10. Verwendung einer Haltevorrichtung (1) nach einem der Ansprüche 1 bis 3, einer Beschichtungsanlage nach einem der Ansprüche 4 bis 5 und/oder eines Verfahrens nach einem der Ansprüche 6 bis 9 bei der Beschichtung, Sinterung und/oder Vergütung von Wafern, Blechen und/oder Keramiken.

## Claims

1. Retaining device (1) for substrates (2) to be coated, comprising a support device (3) for the substrate (2) to be coated, which has a front-side of a planar configuration for supporting the substrate (2) and also a rear-side situated opposite the front-side,
wherein at least one continuous aperture (4) which connects the two sides of the support device (3) is present, via which control of the gas pressure which prevails on the side of the substrate (2) is possible
***characterised in that***
the support device (3) is delimited by at least two oppositely situated retaining elements, wherein the retaining elements are formed by at least two arms (5, 5') which are disposed opposite each other and are delimited by walls (6, 6') and inner edges (7, 7'), the support device (3) and the arms (5, 5') delimiting a region into which the substrate (2) to be coated can be received and the internally situated walls (6, 6') of the arms (5, 5'), orientated towards the region for the substrate (2), having an angle, relative to the support surface for the substrate (2) of the support device (3), of < 90°.

2. Retaining device (1) according to claim 1, **characterised in that** the support device (3) has 2 to 100, preferably 2 to 10, apertures (4).

3. Retaining device (1) according to one of the preceding claims, **characterised in that** a device for producing a low pressure is connected on the rear-side to the at least one aperture (4).

4. Coating plant (10) comprising at least one retaining device (1) according to one of the preceding claims.

5. Coating plant according to the preceding claim, **characterised in that** the coating plant has a tubular coating interior which has at least two retaining devices.

6. Method for coating a substrate (2), **characterised in that** at least one substrate (2) to be coated is introduced into a retaining device (1) of a coating plant according to one of the two preceding claims, is fixed temporarily on the support device (3) and also subsequently is coated.

7. Method according to the preceding claim, **characterised in that** the temporary fixing is effected by the gas pressure in the interior (pᵢ) being increased relative to the gas pressure in the exterior (pₐ), preferably with the device for producing a low pressure.

8. Method according to one of the two preceding claims, **characterised in that** the retaining device (1) with the fixed substrate (2) is disposed vertically, diagonally or horizontally during the coating process, the substrate (2) to be coated being disposed with the area to be coated facing downwards in the case of the diagonal and the horizontal arrangement.

9. Method according to one of the claims 6 to 8, **characterised in that** the coating is effected by means of high-temperature coating methods, CVD- and/or PVD processes, in particular sputtering methods, or PECVD methods.

10. Use of a retaining device (1) according to one of the claims 1 to 3, of a coating plant according to one of the claims 4 to 5 and/or of a method according to one of the claims 6 to 9 in the coating, sintering and/or tempering of wafers, metal sheets and/or ceramics.

## Revendications

1. Dispositif de support (1) pour des substrats (2) à revêtir, comprenant un dispositif d'appui (3) pour le substrat à revêtir (2) qui comporte un côté avant constitué à plat pour l'appui du substrat (2) ainsi qu'un côté arrière opposé au côté avant,
au moins une ouverture (4) continue raccordant les deux côtés du dispositif d'appui (3) étant présente, par le biais de laquelle une régulation de la pression gazeuse régnant sur le côté du substrat (2) est possible,
**caractérisé en ce que**
le dispositif d'appui (3) est limité par au moins deux éléments de support situés en vis-à-vis, les éléments de support étant formés par au moins deux bras (5, 5') disposés en vis-à-vis qui sont limités par des parois (6, 6') et des arêtes intérieures (7, 7'), le dispositif d'appui (3) et les bras (5, 5') limitant une zone dans laquelle le substrat à revêtir (2) peut être reçu, et les parois (6, 6') des bras (5, 5') situées à l'intérieur et tournées vers la zone pour le substrat (2) présentant, par rapport à la surface d'appui du substrat (2) du dispositif d'appui (3), un angle < 90°.

2. Dispositif de support (1) selon la revendication 1, **caractérisé en ce que** le dispositif d'appui (3) dispose de 2 à 100, de préférence de 2 à 10 ouvertures (4).

3. Dispositif de support (1) selon l'une des revendications précédentes, **caractérisé en ce que**, côté arrière, un dispositif de production d'une dépression est relié à l'au moins une ouverture (4).

4. Installation de revêtement (10), comprenant au moins un dispositif de support (1) selon l'une des revendications précédentes.

5. Installation de revêtement selon la revendication précédente, **caractérisée en ce que** l'installation de revêtement comporte un espace intérieur de revêtement de forme tubulaire qui comporte au moins deux dispositifs de support.

6. Procédé de revêtement d'un substrat (2), **caractérisé en ce qu'**au moins un substrat à revêtir (2) est introduit dans un dispositif de support (1) d'une installation de revêtement selon l'une des deux revendications précédentes, est fixé de façon temporaire sur le dispositif d'appui (3) après quoi il est revêtu.

7. Procédé selon la revendication précédente, **caractérisé en ce que** la fixation temporaire s'effectue par le fait que la pression gazeuse dans l'espace intérieur (pᵢ) est augmentée par rapport à la pression gazeuse dans l'espace extérieur (pₐ), de préférence avec le dispositif de production d'une dépression.

8. Procédé selon l'une des deux revendications précédente, **caractérisé en ce que**, pendant le processus de revêtement, le dispositif de support (1) avec le substrat (2) fixé est disposé de façon verticale, diagonale ou horizontale, le substrat à revêtir (2) étant, en cas de disposition diagonale et horizontale, disposé avec la surface à revêtir vers le bas.

9. Procédé selon l'une des deux revendications 6 à 8, **caractérisé en ce que** le revêtement s'effectue au moyen d'un procédé de revêtement à température élevée, de processus CVD et/ou PVD, en particulier d'un procédé de pulvérisation cathodique, ou d'un procédé de PECVD.

10. Utilisation d'un dispositif de support (1) selon l'une des revendications 1 à 3, d'une installation de revêtement selon l'une des revendications 4 à 5 et/ou d'un procédé selon l'une des revendications 6 à 9 lors du revêtement, du frittage et/ou du traitement par trempe et revenu de tranches, tôles et/ou céramiques.
